# EUROPEAN PATENT APPLICATION

(11) **EP 4 577 019 A1**
(43) Date of publication of application: **25.06.2025**
(21) Application number: 24214607.4
(22) Date of filing: 21.11.2024
(51) Int. Cl.: H10K 59/122, H10K 59/80

(54) **DISPLAY DEVICE AND METHOD FOR FABRICATION THEREOF**

(30) Priority: 20.12.2023 KR 20230187508
(71) Applicant: Samsung Display Co., Ltd., Yongin-si, Gyeonggi-do 17113 (KR)
(72) Inventor: SONG, Do Keun, Yongin-si (KR); KWON, Yeong Woo, Yongin-si (KR); KIM, Dong Jun, Yongin-si (KR); KIM, Hyoung Sik, Yongin-si (KR); CHOI, Jong Hoon, Yongin-si (KR)
(74) Representative: Marks & Clerk LLP

(57) **Abstract**

A display device includes: a first electrode disposed on a substrate; a first auxiliary electrode disposed on the first electrode, and having a width narrower than the first electrode; a light emitting layer disposed on the first auxiliary electrode; a second electrode disposed on the light emitting layer; and a pixel defining layer comprising a body portion disposed on a portion of the first electrode and the substrate, not on the second electrode, and a protrusion portion disposed on the second electrode.

## Description

### BACKGROUND

### 1. Technical Field

The present disclosure relates to a display device and a method for fabrication thereof.

### 2. Description of the Related Art

With the advance of information-oriented society, more and more demands are placed on display devices for displaying images in various ways. For example, display devices are employed in various electronic devices such as smartphones, digital cameras, laptop computers, navigation devices, and smart televisions. The display device may be a flat panel display device such as a liquid crystal display device, a field emission display device or an organic light emitting display device. Among the flat panel display devices, in the light emitting display device, since each of the pixels of a display panel includes a light emitting element capable of emitting light by itself, an image can be displayed without a backlight unit providing light to the display panel.

The display device is employed in a glass-type device for providing virtual reality and augmented reality. In order to be employed in the glass-type device, the display device needs to be implemented in a very small size of 2 inches or less, or needs to have a high pixel pitch to be implemented with high resolution. For example, the display device may have a high pixel pitch of 400 pixels per inch ("PPI") or more.

In this way, when the display device is implemented in a very small size or has a high pixel pitch, it is difficult to implement light emitting elements separated for each emission area by a mask process because the area of the emission area where the light emitting element is disposed is reduced.

### SUMMARY

Aspects of the present disclosure provide a display device capable of forming light emitting elements separated for each emission area without a mask process.

Aspects of the present disclosure also provide a display device with low resistance of a light emitting element.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

According to an embodiment of the present disclosure, a display device includes a first electrode disposed on a substrate; a first auxiliary electrode disposed on the first electrode, and having a width narrower than the first electrode; a light emitting layer disposed on the first auxiliary electrode; a second electrode disposed on the light emitting layer; and a pixel defining layer including a body portion disposed on a portion of the first electrode and the substrate, not on the second electrode, and a protrusion portion disposed on the second electrode.

The side of the protrusion portion of the pixel defining layer may protrude more than the side of the body portion toward a center of the second electrode in a plan view.

The first auxiliary electrode may be disposed on the side of the body portion of the pixel defining layer.

The width of the protrusion portion of the pixel defining layer may be 0.1 micrometers (µm) to 1.5 µm.

The display device may further include a first connection electrode disposed on the body portion and the protrusion portion of the pixel defining layer, and including the same material as the first auxiliary electrode.

The thickness of the first auxiliary electrode and the thickness of the first connection electrode may be the same.

The display device may further include a second auxiliary electrode disposed on the second electrode.

The thickness of the second auxiliary electrode may be greater than the thickness of the first auxiliary electrode.

The first auxiliary electrode, the first connection electrode, and the second auxiliary electrode may contain transparent conductive oxide ("TCO").

The display device may further include a second connection electrode disposed on the second auxiliary electrode and the first connection electrode.

The first auxiliary electrode and the first connection electrode may contain Indium Tin Oxide ("ITO") or Tungsten Oxide (WOₓ), and the second auxiliary electrode and the second connection electrode may contain Indium Zinc Oxide ("IZO"), Indium Tin Zinc Oxide ("ITZO"), Zinc Indium Tin Oxide ("ZITO"), or Indium Gallium Zinc Oxide ("IGZO").

The second auxiliary electrode may be disposed on the side and the upper surface of the protrusion portion of the pixel defining layer.

The display device may further include a second connection electrode directly disposed on the second electrode and the first connection electrode.

The pixel defining layer may contain at least one of silicon nitride, silicon oxynitride, or silicon oxide.

The pixel defining layer may be a single layer or a multilayer.

The body portion of the pixel defining layer may include a first layer and a second layer, and the protrusion portion of the pixel defining layer may include the first layer.

The thickness of the protrusion portion of the pixel defining layer may be smaller than the minimum thickness of the body portion of the pixel defining layer.

According to an embodiment of the present disclosure, a display device includes a substrate comprising a first emission area and a second emission area; a pixel defining layer comprising a body portion disposed on the substrate and a protrusion portion defining the first emission area and the second emission area but spaced apart from the upper surface of the substrate; a first electrode, a first auxiliary electrode, a light emitting layer, and a second electrode sequentially disposed on the substrate in the first emission area; a first electrode, a first auxiliary electrode, a light emitting layer, and a second electrode sequentially disposed on the substrate in the second emission area; and a connection electrode disposed on the second electrodes and the pixel defining layer, wherein the second electrode of the first emission area and the second electrode of the second emission area are spaced apart from each other and electrically connected through the connection electrode, and at least a portion of the second electrode of the first emission area and at least a portion of the second electrode of the second emission area are disposed between the substrate and the protrusion portion of the pixel defining layer in a thickness direction of the substrate.

The connection electrode may include a first connection electrode disposed on the pixel defining layer; and a second connection electrode disposed on the second electrode and the first connection electrode, wherein the first connection electrode and the second connection electrode comprise different materials from each other.

The display device may further include a second auxiliary electrode disposed on the second electrode and the connection electrode of the first emission area; and a second auxiliary electrode disposed on the second electrode and the connection electrode of the second emission area, wherein the second auxiliary electrodes may be spaced apart from each other.

According to an embodiment of the present disclosure, a method for fabrication of a display device includes: forming a plurality of first electrodes spaced apart from each other on a substrate; forming a temporary layer on the substrate and the first electrodes; patterning the temporary layer to expose edges of the first electrodes and a portion of the substrate; forming a pixel defining material layer on the substrate, the first electrodes, and the patterned temporary layer; removing a portion of the pixel defining material layer to expose a portion of the patterned temporary layer; and removing the patterned temporary layer to form an opening of the pixel defining material layer.

The method may further include: forming a first auxiliary electrode on the first electrodes, and the first connection electrode on the pixel defining material layer; forming a light emitting layer on the first auxiliary electrode and a sub-light emitting layer on the first connection electrode; forming a second electrode on the light emitting layer and a second sub-electrode on the sub-light emitting layer; forming a first inorganic layer on the second electrode and the second sub-electrode; removing a portion of the first inorganic layer; and removing the second sub-electrode and the sub-light emitting layer to expose the first connection electrode.

At least some of the above and other features of the invention are set out in the claims.

In a display device and a method for fabrication thereof according to one embodiment, a pixel defining layer has an opening and an undercut structure and a light emitting element is disposed inside the undercut structure. A connection electrode covering the light emitting elements spaced apart from each other may be disposed to lower the resistance of the light emitting elements.

However, effects according to the embodiments of the present disclosure are not limited to those exemplified above and various other effects are incorporated herein.

### BRIEF DESCRIPTION OF THE DRAWINGS

The above and other aspects and features of the present disclosure will become more apparent by describing in detail embodiments thereof with reference to the attached drawings, in which:
FIG. 1 is a perspective view illustrating a display device according to one embodiment;
FIG. 2 is a cross-sectional view of the display device of FIG. 1 viewed from the side;
FIG. 3 is a plan view showing a layout of an emission area of a display device according to one embodiment;
FIG. 4 is a cross-sectional view illustrating a part of a display device according to one embodiment;
FIG. 5 is an enlarged view showing a first emission area of FIG. 4;
FIGS. 6 to 10 are enlarged views showing the first emission area of FIG. 4 according to other embodiments; and
FIGS. 11 to 24 are cross-sectional views sequentially illustrating a fabrication process of a display device according to one embodiment.

### DETAILED DESCRIPTION

The invention will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification. In contrast, when an element is referred to as being "directly on" another element, there are no intervening elements present.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the invention. Similarly, the second element could also be termed the first element.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof. Hereinafter, embodiments will be described with reference to the accompanying drawings.

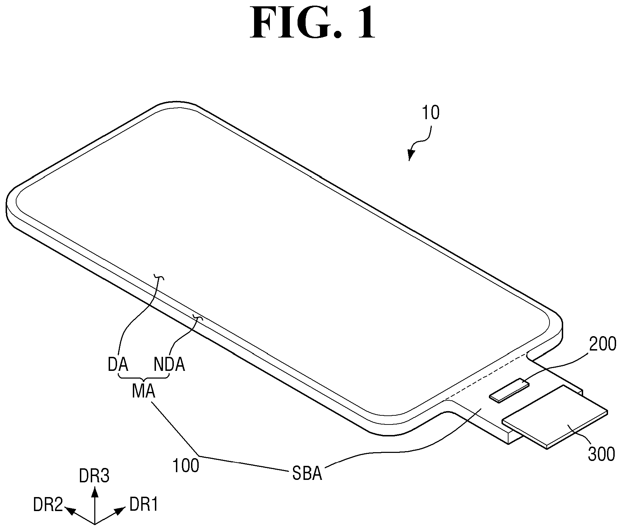

FIG. 1 is a perspective view illustrating a display device according to one embodiment.

Referring to FIG. 1, a display device 10 according to one embodiment may be included in an electronic device and may provide a screen displayed on the electronic device. The electronic device may refer to any electronic device providing a display screen. Examples of the electronic device may include a television, a laptop computer, a monitor, a billboard, an Internet-of-Things device, a mobile phone, a smartphone, a tablet personal computer ("PC"), an electronic watch, smart glasses, a smart watch, a watch phone, a head-mounted display, a mobile communication terminal, an electronic notebook, an electronic book, a portable multimedia player ("PMP"), a navigation device, a game machine, a digital camera, a camcorder and the like, which provide a display screen.

The shape of the display device 10 may be variously modified. For example, the display device 10 may have a shape similar to a rectangular shape having a short side in a first direction DR1 and a long side in a second direction DR2. The edge where the short side in the first direction DR1 and the long side in the second direction DR2 meet may be rounded to have a curvature, but is not limited thereto and may be formed at a right angle. The shape of the display device 10 in a plan view is not limited to a quadrilateral shape, and may be formed in a shape similar to another polygonal shape, a circular shape, or elliptical shape.

The display device 10 may include a display panel 100, a display driver 200, a circuit board 300, and a touch driver 400.

The display panel 100 may include a main region MA and a sub-region SBA.

The main region MA may include a display area DA including pixels displaying an image and a non-display area NDA disposed around the display area DA. The display area DA may emit light from a plurality of emission areas or a plurality of opening areas. For example, the display panel 100 may include a pixel circuit including switching elements, a pixel defining layer defining an emission area or an opening area, and a self-light emitting element.

For example, the self-light emitting element may include at least one of an organic light emitting diode ("LED") including an organic light emitting layer, a quantum dot LED including a quantum dot light emitting layer, an inorganic LED including an inorganic semiconductor, or a micro LED, but is not limited thereto.

A plurality of pixels, a plurality of scan lines, a plurality of data lines, and a plurality of power lines may be disposed in the display area DA. Each of the plurality of pixels may be defined as a minimum unit that emits light, and each of the above-described self-light emitting elements may be each pixel. The plurality of scan lines may supply a scan signal received from a scan driver to the plurality of pixels. The plurality of data lines may supply the data voltages received from the display driver 200 to the plurality of pixels. The plurality of power lines may supply the power voltages received from the display driver 200 to the plurality of pixels.

The non-display area NDA may be an area outside the display area DA. The non-display area NDA may be defined as an edge area of the main region MA of the display panel 100. The non-display area NDA may include a scan driver that supplies scan signals to the scan lines, and fan-out lines that connect the display driver 200 to the display area DA.

The sub-region SBA may be a region extending from one side of the main region MA. The sub-region SBA may include a flexible material which can be bent, folded or rolled. For example, when the sub-region SBA is bent, the sub-region SBA may overlap the main region MA in a thickness direction (third direction DR3). The sub-region SBA may include the display driver 200 and a pad portion connected to the circuit board 300. In another embodiment, the sub-region SBA may be omitted, and the display driver 200 and the pad portion may be arranged in the non-display area NDA.

The display driver 200 may output signals and voltages for driving the display panel 100. The display driver 200 may supply data voltages to data lines. The display driver 200 may supply a power voltage to the power line and may supply a scan control signal to the scan driver. The display driver 200 may be formed as an integrated circuit ("IC") and mounted on the display panel 100 by a chip on glass ("COG") method, a chip on plastic ("COP") method, or an ultrasonic bonding method. For example, the display driver 200 may be disposed in the sub-region SBA, and may overlap the main region MA in the thickness direction (third direction DR3) by bending of the sub-region SBA. For another example, the display driver 200 may be mounted on the circuit board 300.

The circuit board 300 may be attached to the pad portion of the display panel 100 by using an anisotropic conductive film ("ACF"). Lead lines of the circuit board 300 may be electrically connected to the pad portion of the display panel 100. The circuit board 300 may be a flexible printed circuit board, a printed circuit board, or a flexible film such as a chip on film.

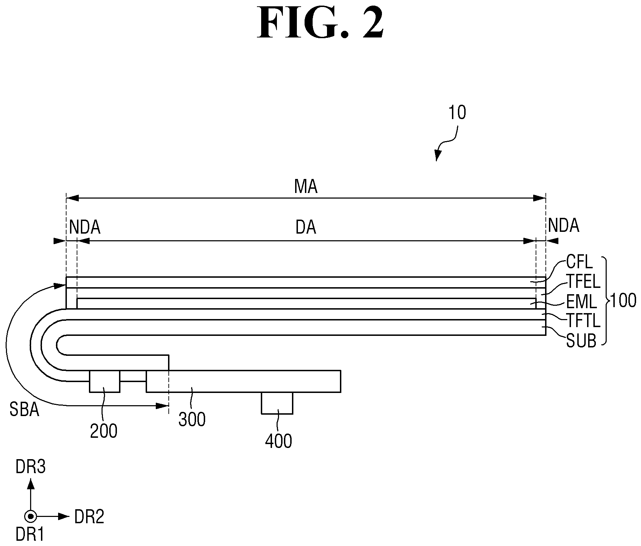

FIG. 2 is a cross-sectional view of the display device of FIG. 1 viewed from the side. Specifically, it presents a side view of the display device of FIG. 1 which is in a folded state.

Referring to FIG. 2, the display panel 100 may include a substrate SUB, a thin film transistor layer TFTL, a light emitting element layer EML, a thin film encapsulation layer TFEL, and a color filter layer CFL.

The substrate SUB may be a base substrate or a base member. The substrate SUB may be a flexible substrate which can be bent, folded or rolled. For example, the substrate SUB may include a polymer resin such as polyimide ("PI"), but is not limited thereto. In another embodiment, the substrate SUB may include a glass material or a metal material.

The thin film transistor layer TFTL may be disposed on the substrate SUB. The thin film transistor layer TFTL may include a plurality of thin film transistors constituting a pixel circuit of pixels. The thin film transistor layer TFTL may further include scan lines, data lines, power lines, scan control lines, fan-out lines that connect the display driver 200 to the data lines, and lead lines that connect the display driver 200 to the pad portion. Each of the thin film transistors may include a semiconductor region, a source electrode, a drain electrode, and a gate electrode. For example, when the scan driver is formed on one side of the non-display area NDA of the display panel 100, the scan driver may include thin film transistors.

The thin film transistor layer TFTL may be disposed in the display area DA, the non-display area NDA, and the sub-region SBA. Thin film transistors, scan lines, data lines, and power lines of each of the pixels of the thin film transistor layer TFTL may be disposed in the display area DA. The scan control lines and fan-out lines of the thin film transistor layer TFTL may be disposed in the non-display area NDA. The lead lines of the thin film transistor layer TFTL may be disposed in the sub-region SBA.

The light emitting element layer EML may be disposed on the thin film transistor layer TFTL. The light emitting element layer EML may include a plurality of light emitting elements each including a first electrode, a second electrode, and a light emitting layer to emit light, and a pixel defining layer defining pixels. The plurality of light emitting elements of the light emitting element layer EML may be disposed in the display area DA.

In one embodiment, the light emitting layer may include an organic material. The light emitting layer may include a hole transporting layer, an organic light emitting layer, and an electron transporting layer. When the first electrode receives an anode voltage through the thin film transistor of the thin film transistor layer TFTL and the second electrode receives the cathode voltage, holes and electrons may be transferred to the organic light emitting layer through the hole transporting layer and the electron transporting layer, respectively and may be combined with each other to emit light in the organic light emitting layer.

In another embodiment, the light emitting elements may include a quantum dot light emitting diode including a quantum dot light emitting layer, an inorganic light emitting diode including an inorganic semiconductor, or a micro light emitting diode.

The thin film encapsulation layer TFEL may cover the top surface and the side surface of the light emitting element layer EML, and may protect the light emitting element layer EML. The thin film encapsulation layer TFEL may include at least one inorganic layer and at least one organic layer for encapsulating the light emitting element layer EML.

The color filter layer CFL may be disposed on the thin film encapsulation layer TFEL. The color filter layer CFL may include a plurality of color filters corresponding to the plurality of emission areas, respectively. Each of the color filters may selectively transmit light of a specific wavelength and may block or absorb light of a different wavelength. The color filter layer CFL may absorb a part of light coming from the outside of the display device 10 to reduce reflected light due to external light. Accordingly, the color filter layer CFL may prevent color distortion caused by reflection of the external light.

Since the color filter layer CFL is directly disposed on the thin film encapsulation layer TFEL, the display device 10 may not require a separate substrate for the color filter layer CFL. Accordingly, the thickness of the display device 10 may be relatively small.

In some embodiments, the display device 10 may further include an optical device. The optical device may emit or receive light in infrared, ultraviolet, and visible light bands. For example, the optical device may be an optical sensor that detects light incident on the display device 10 such as a proximity sensor, an illuminance sensor, a camera sensor, a fingerprint sensor, or an image sensor.

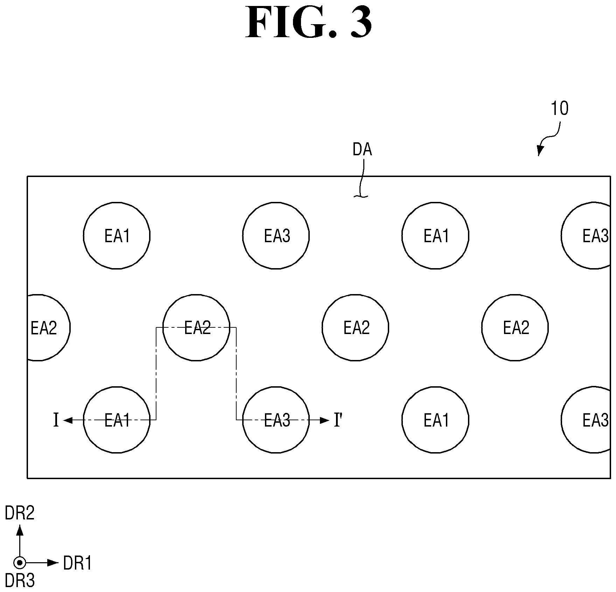

FIG. 3 is a plan view illustrating a part of a display device according to one embodiment. FIG. 3 is a plan view illustrating the layout of emission areas EA1, EA2, and EA3 in the display area DA of the display device 10. As used herein, the "plan view" is a view in a thickness direction (DR3) of the substrate SUB.

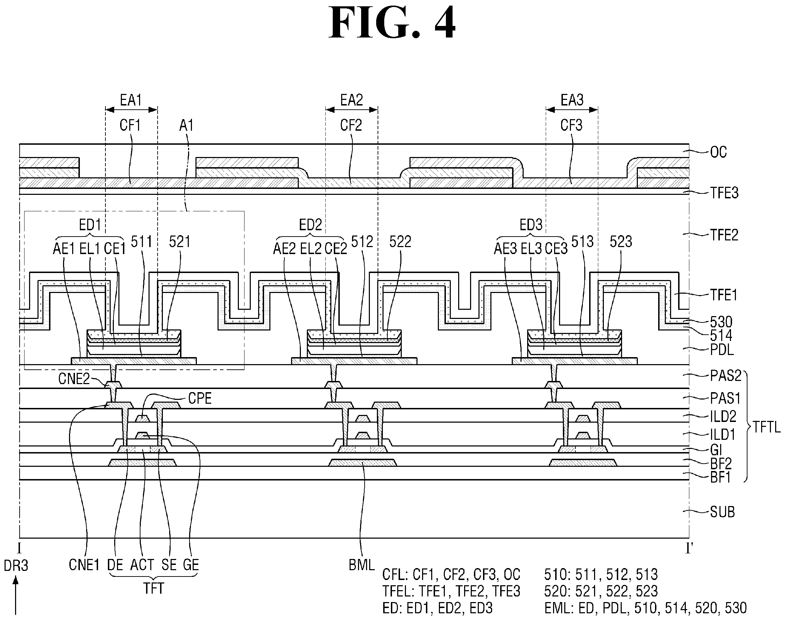

Referring to FIG. 3, the display device 10 may include a plurality of emission areas EA1, EA2, and EA3 disposed in the display area DA. The emission areas EA1, EA2, and EA3 may include a first emission area EA1, a second emission area EA2, and a third emission area EA3 that emit light of different colors. The first to third emission areas EA1, EA2, and EA3 may emit red, green, or blue light, respectively, and the color of light emitted from each of the emission areas EA1, EA2, and EA3 may be different depending on the types of emission elements ('ED1', 'ED2', and 'ED3' in FIG. 4) to be described later. As an example, the first emission area EA1 may emit a first light of red color, the second emission area EA2 may emit a second light of green color, and the third emission area EA3 may emit a third light of blue color. However, the present disclosure is not limited thereto.

The plurality of emission areas EA1, EA2, and EA3 may be disposed in a pentile^{™} type, for example, a diamond pentile^{™} type. For example, the first emission area EA1 and the third emission area EA3 may be disposed to be spaced apart from each other in the first direction DR1, and may be alternately disposed in the first direction DR1 and the second direction DR2. The second emission area EA2 may be spaced apart from another adjacent second emission area EA2 in the first direction DR1 and the second direction DR2. The second emission area EA2 and the first emission area EA1, or the second emission area EA2 and the third emission area EA3 may be alternately arranged along any direction in a plane formed by the first direction DR1 and the second direction DR2.

The first to third emission areas EA1, EA2, and EA3 may be defined by a pixel defining layer ('PDL' in FIG. 4) to be described later.

FIG. 4 is a cross-sectional view illustrating a portion of the display device according to one embodiment. Specifically, FIG. 4 is a cross-sectional view of portion taken along line I-I' of FIG. 3. Referring to FIG. 4, a thin film transistor layer TFTL, a light emitting element layer EML, a thin film encapsulation layer TFEL, and a color filter layer CFL may be sequentially stacked on a substrate SUB.

The thin film transistor layer TFTL may include a first buffer layer BF1, a lower metal layer BML, a second buffer layer BF2, a thin film transistor TFT, a gate insulating layer GI, a first interlayer-insulating layer ILD1, a capacitor electrode CPE, a second interlayer-insulating layer ILD2, a first contact electrode CNE1, a first passivation layer PAS1, a second contact electrode CNE2, and a second passivation layer PAS2.

The first buffer layer BF1 may be disposed on the substrate SUB. The first buffer layer BF1 may include an inorganic layer capable of preventing permeation of air or moisture. For example, the first buffer layer BF1 may include a plurality of inorganic layers alternately stacked.

The lower metal layer BML may be disposed on the first buffer layer BF1. For example, the lower metal layer BML may be formed of a single layer or a multi-layer made of any one of molybdenum (Mo), aluminium (Al), chromium (Cr), gold (Au), titanium (Ti), nickel (Ni), neodymium (Nd), and copper (Cu), or an alloy thereof.

The second buffer layer BF2 may cover the first buffer layer BF1 and the lower metal layer BML. The second buffer layer BF2 may include an inorganic layer capable of preventing permeation of air or moisture. For example, the second buffer layer BF2 may include a plurality of inorganic layers alternately stacked.

The thin film transistor TFT may be disposed on the second buffer layer BF2, and may constitute a pixel circuit of each of a plurality of pixels. For example, the thin film transistor TFT may be a switching transistor or a driving transistor of the pixel circuit. The thin film transistor TFT may include a semiconductor layer ACT, a source electrode SE, a drain electrode DE, and a gate electrode GE.

The semiconductor layer ACT may be disposed on the second buffer layer BF2. The semiconductor layer ACT may overlap the lower metal layer BML and the gate electrode GE in the thickness direction DR3, and may be insulated from the gate electrode GE by the gate insulating layer GI. In a part of the semiconductor layer ACT, a material of the semiconductor layer ACT may be made into a conductor to form the source electrode SE and the drain electrode DE.

The gate electrode GE may be disposed on the gate insulating layer GI. The gate electrode GE may overlap the semiconductor layer ACT in the thickness direction DR3 with the gate insulating layer GI interposed therebetween.

The gate insulating layer GI may be disposed on the semiconductor layer ACT. For example, the gate insulating layer GI may cover the semiconductor layer ACT and the second buffer layer BF2 to insulate the gate electrode GE from the semiconductor layer ACT. The gate insulating layer GI may include a contact hole through which the first contact electrode CNE1 passes.

The first interlayer-insulating layer ILD1 may cover the gate electrode GE and the gate insulating layer GI. The first interlayer-insulating layer ILD1 may include a contact hole through which the first contact electrode CNE1 passes. The contact hole of the first interlayer-insulating layer ILD1 may be connected to the contact hole of the gate insulating layer GI and the contact hole of the second interlayer-insulating layer ILD2.

The capacitor electrode CPE may be disposed on the first interlayer-insulating layer ILD1. The capacitor electrode CPE may overlap the gate electrode GE in the thickness direction DR3. The capacitor electrode CPE and the gate electrode GE may form a capacitance.

The second interlayer-insulating layer ILD2 may cover the capacitor electrode CPE and the first interlayer-insulating layer ILD1. The second interlayer-insulating layer ILD2 may include a contact hole through which the first contact electrode CNE1 passes. The contact hole of the second interlayer-insulating layer ILD2 may be connected to the contact hole of the first interlayer-insulating layer ILD 1 and the contact hole of the gate insulating layer GI.

The first contact electrode CNE1 may be disposed on the second interlayer-insulating layer ILD2. The first contact electrode CNE1 may electrically connect the drain electrode DE of the thin film transistor TFT to the second contact electrode CNE2. The first contact electrode CNE1 may be inserted into a contact hole provided in the second interlayer-insulating layer ILD2, the first interlayer-insulating layer ILD1, and the gate insulating layer GI to be in contact with the drain electrode DE of the thin film transistor TFT.

The first passivation layer PAS1 may cover the first contact electrode CNE1 and the second interlayer-insulating layer ILD2. The first passivation layer PAS 1 may protect the thin film transistor TFT. The first passivation layer PAS1 may include a contact hole through which the second contact electrode CNE2 passes.

The second contact electrode CNE2 may be disposed on the first passivation layer PAS 1. The second contact electrode CNE2 may electrically connect the first contact electrode CNE1 to first electrodes AE1, AE2, and AE3 of a light emitting element ED. The second contact electrode CNE2 may be inserted into a contact hole formed in the first passivation layer PAS1 to be in contact with the first contact electrode CNE1.

The second passivation layer PAS2 may cover the second contact electrode CNE2 and the first passivation layer PAS1. The second passivation layer PAS2 may include a contact hole through which the first electrodes AE1, AE2, and AE3 of the light emitting element ED pass.

The light emitting element layer EML may be disposed on the thin film transistor layer TFTL. The light emitting element layer EML may include the light emitting element ED, a pixel defining layer PDL, a capping layer (not shown), and a bank (not shown). The light emitting element ED may include the first electrodes AE1, AE2, and AE3, light emitting layers EL1, EL2, and EL3, and second electrodes CE1, CE2, and CE3.

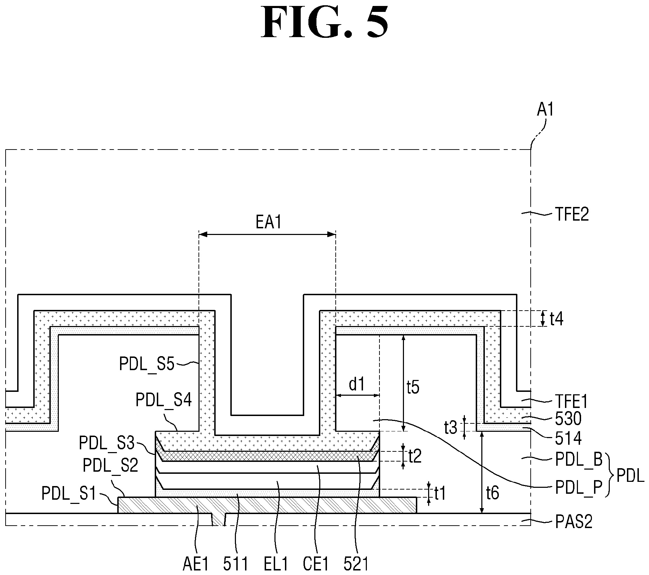

FIG. 5 is an enlarged view showing a first emission area EA1 of FIG. 4, specifically area A1.

Referring to FIG. 5 in addition to FIG. 4, the display device 10 may include a plurality of emission areas EA1, EA2, and EA3 disposed in the display area DA. The emission areas EA1, EA2, and EA3 may be defined as areas in which light is emitted from light emitting elements ED1, ED2, and ED3 including the first electrodes AE1, AE2, and AE3, the light emitting layers EL1, EL2, and EL3, and the second electrodes CE1, CE2, and CE3, respectively, and may extend in a thickness direction DR3 of the substrate SUB. The boundary of the emission areas EA1, EA2, and EA3 may be defined by the pixel defining layer PDL. The emission areas EA1, EA2, and EA3 may include a first emission area EA1, a second emission area EA2, and a third emission area EA3 spaced apart from each other and emitting light of the same or different colors.

In one embodiment, the areas or sizes of the first to third emission areas EA1, EA2, and EA3 may be the same. For example, in the display device 10, the first emission area EA1, the second emission area EA2, and the third emission area EA3 may have the same area. However, the present disclosure is not limited thereto. In the display device 10, the areas or sizes of the first to third emission areas EA1, EA2, and EA3 may be different from each other. For example, the area of the second emission area EA2 may be smaller than each of the areas of the first emission area EA1 and the third emission area EA3, and the area of the third emission area EA3 may be greater than the area of the first emission area EA1. The intensity of light emitted from the corresponding emission areas EA1, EA2, and EA3 may vary according to the areas of the emission areas EA1, EA2, and EA3, and the areas of the emission areas EA1, EA2, and EA3 may be adjusted to control the color of the screen displayed on the display device 10. Although it is illustrated in the embodiment of FIG. 4 that the emission areas EA1, EA2, and EA3 have the same area, the present disclosure is not limited thereto.

In the display device 10, one first emission area EA1, one second emission area EA2, and one third emission area EA3 disposed adjacent to each other may form one pixel group. One pixel group may include the emission areas EA1, EA2, and EA3 emitting light of different colors to express a white grayscale. However, the present disclosure is not limited thereto, and the combination of the emission areas EA1, EA2, and EA3 constituting one pixel group may be variously modified depending on the arrangement of the emission areas EA1, EA2, and EA3, the color of the light emitted from the emission areas EA1, EA2, and EA3, and the like.

The display device 10 may include the plurality of light emitting elements ED1, ED2, and ED3 disposed in the different emission areas EA1, EA2, and EA3. The light emitting elements ED1, ED2, and ED3 may include the first light emitting element ED1 disposed in the first emission area EA1, the second light emitting element ED2 disposed in the second emission area EA2, and the third light emitting element ED3 disposed in the third emission area EA3.

The light emitting elements ED1, ED2, and ED3 may include the first electrodes AE1, AE2, and AE3, the light emitting layers EL1, EL2, and EL3, and the second electrodes CE1, CE2, and CE3, respectively, and the light emitting elements ED1, ED2, and ED3 disposed in the different emission areas EA1, EA2, and EA3 may emit lights of different colors depending on the materials of the light emitting layers EL1, EL2, and EL3. For example, the first light emitting element ED1 disposed in the first emission area EA1 may emit red light having a peak wavelength within a range of 610 nm to 650 nm, the second light emitting element ED2 disposed in the second emission area EA2 may emit green light having a peak wavelength within a range of 510 nm to 550 nm, and the third light emitting element ED3 disposed in the third emission area EA3 may emit blue light having a peak wavelength within a range of 440 nm to 480 nm. The first to third emission areas EA1, EA2, and EA3 constituting one pixel may include the light emitting elements ED1, ED2, and ED3, respectively, for emitting lights of different colors to express a white grayscale. Alternatively, the light emitting layers EL1, EL2, and EL3 may include two or more materials emitting lights of different colors, so that one light emitting layer may emit mixed light. For example, the light emitting layers EL1, EL2, and EL3 may include a red light emitting material and a green light emitting material to emit yellow light, or may include the red light emitting material, the green light emitting material, and a blue light emitting material to emit white light.

The first electrodes AE1, AE2, and AE3 may be disposed on the second passivation layer PAS2. The first electrodes AE1, AE2, and AE3 may be disposed in the plurality of emission areas EA1, EA2, and EA3, respectively. The plurality of first electrodes AE1, AE2, and AE3 may include a first electrode AE1 disposed in the first emission area EA1, a first electrode AE2 disposed in the second emission area EA2, and a first electrode AE3 disposed in the third emission area EA3. The first electrodes AE1, AE2, and AE3 overlapping the first to third emission areas EA1, EA2, and EA3, respectively, may be disposed to be spaced apart from each other on the second passivation layer PAS2.

The first electrodes AE1, AE2, and AE3 may be electrically connected to the drain electrode DE of the thin film transistor TFT through the first and second contact electrodes CNE1 and CNE2. The edges of the first electrodes AE1, AE2, and AE3 spaced apart from each other may be covered by the pixel defining layer PDL, so that the first to third electrodes AE1, AE2, and AE3 may be insulated from each other.

The first electrodes AE1, AE2, and AE3 may include a transparent conductive oxide material or/and a conductive metal material. The metal material may be at least one of silver (Ag), copper (Cu), aluminium (Al), nickel (Ni), lanthanum (La), titanium (Ti), or titanium nitride (TiN). The transparent conductive oxide material may be at least one of indium tin oxide (ITO), indium zinc oxide (IZO), indium tin zinc oxide (ITZO), zinc indium tin oxide (ZITO), indium gallium zinc oxide (IGZO), zinc tin oxide (ZTO), or tungsten oxide (WOₓ). The first electrodes AE1, AE2, and AE3 may have a multilayer structure of a transparent conductive oxide material and a conductive metal material. In one embodiment, the first electrodes AE1, AE2, and AE3 may have a structure of ITO/Ag/ITO.

A first auxiliary electrode 510 may be disposed on the first electrodes AE1, AE2, and AE3. First auxiliary electrodes 511, 512, and 513 may be disposed in a plurality of emission areas EA1, EA2, and EA3, and may be spaced apart from each other. The plurality of first auxiliary electrodes 510 may include a first auxiliary electrode 511 disposed in the first emission area EA1, a first auxiliary electrode 512 disposed in the second emission area EA2, and a first auxiliary electrode 513 disposed in the third emission area EA3. The first auxiliary electrodes 511, 512, and 513 may transmit voltages of the first electrodes AE1, AE2, and AE3 to the light emitting layers EL1, EL2, and EL3, and insert or deliver holes.

The first auxiliary electrodes 511, 512, and 513 may have smaller widths than the first electrodes AE1, AE2, and AE3 disposed below, respectively. As used herein, the "width" is measured in a direction perpendicular to the third direction DR3 in a cross-sectional view. A portion of the first auxiliary electrodes 511, 512, and 513 may be disposed on a side surface of the pixel defining layer PDL. The portion of the first electrodes AE1, AE2, and AE3 may not be covered by the first auxiliary electrodes 511, 512, and 513 and be exposed. The exposed top surfaces of the first electrodes AE1, AE2, and AE3 may be covered by the pixel defining layer PDL. The entire lower surface of the first auxiliary electrodes 511, 512, and 513 may be in contact with the first electrodes AE1, AE2, and AE3.

The first auxiliary electrodes 511, 512, and 513 may include transparent conductive oxide (TCO). The transparent conductive oxide material of the first auxiliary electrodes 511, 512, and 513 may be the material exemplified for the first electrodes AE1, AE2, and AE3. In one embodiment, the first auxiliary electrodes 511, 512, and 513 may include indium tin oxide (ITO) or/and tungsten oxide (WOₓ).

The light emitting layers EL1, EL2, and EL3 may be disposed on the first auxiliary electrodes 511, 512, and 513, respectively. The light emitting layers EL1, EL2, and EL3 may be organic light emitting layers made of an organic material, and may be formed on the first electrodes AE1, AE2, and AE3, respectively, by the deposition process. The light emitting layers EL1, EL2, and EL3 may have a multilayer structure, and each of a hole injection material, a hole transport material, a light emitting material, an electron transport material, and/or an electron injection material may form a layer. When the thin film transistor TFT applies a predetermined voltage to the first electrodes AE1, AE2, and AE3 of the light emitting elements ED1, ED2, and ED3, and the second electrodes CE1, CE2, and CE3 of the light emitting elements ED1, ED2, and ED3 receive a common voltage or a cathode voltage, holes and electrons may be injected and transported, and may be combined with each other to emit light in the light emitting layers EL1, EL2, and EL3.

The light emitting layers EL1, EL2, and EL3 may be disposed in different emission areas EA1, EA2, and EA3, respectively, and may be spaced apart from each other. The plurality of light emitting layers EL1, EL2, and EL3 may include a light emitting layer EL1 in the first emission area EA1, a light emitting layer EL2 in the second emission area EA2, and a light emitting layer EL3 in the third emission area EA3. The plurality of light emitting layers EL1, EL2, and EL3 may emit lights of different colors, or one light emitting layer EL1, EL2, EL3 may emit mixed light. In one embodiment, the light emitting layer EL1 of the first emission area EA1 may emit red light, the light emitting layer EL2 of the second emission area EA2 may emit green light, and the light emitting layer EL3 of the third emission area EA3 may emit blue light. In another embodiment, the light emitting layer EL1 of the first emission area EA1 may emit yellow light that is mixed light of red light and green light, and the light emitting layer EL2 of the second emission area EA2 may emit blue light. In yet another embodiment, the light emitting layer EL1 of the first emission area EA1 may emit white light, which is a mixture of red light, green light, and blue light.

The second electrodes CE1, CE2, and CE3 may be disposed on the light emitting layers EL1, EL2, and EL3, respectively. The second electrodes CE1, CE2, and CE3 may include a transparent conductive material, so that the light generated in the light emitting layers EL1, EL2, and EL3 may be emitted. The second electrodes CE1, CE2, and CE3 may receive a common voltage or a low potential voltage. When the first electrodes AE1, AE2, and AE3 receive the voltage corresponding to a data voltage and the second electrodes CE1, CE2, and CE3 receive the low potential voltage, a potential difference is formed between the first electrodes AE1, AE2, and AE3 and the second electrodes CE1, CE2, and CE3, so that the light emitting layers EL1, EL2, and EL3 may emit light.

The second electrodes CE1, CE2, and CE3 may be disposed in emission areas EA1, EA2, and EA3 different from each other, respectively, and spaced apart from each other. The plurality of second electrodes CE1, CE2, and CE3 may include a second electrode CE1 of the first emission area EA1, a second electrode CE2 of the second emission area EA2, and a second electrode CE3 of the third emission area EA3.

A second auxiliary electrode 520 may be disposed on the second electrodes CE1, CE2, and CE3. The second auxiliary electrodes 521, 522, and 523 may be disposed in a plurality of emission areas EA1, EA2, and EA3, respectively, and may be spaced apart from each other. The plurality of second auxiliary electrodes 520 may include a second auxiliary electrode 521 disposed in the first emission area EA1, a second auxiliary electrode 522 disposed in the second emission area EA2, and a second auxiliary electrode 523 disposed in the third emission area EA3. The second auxiliary electrodes 521, 522, and 523 may transmit voltage of a first connection electrode 514 or a second connection electrode 530 to the second electrodes CE1, CE2, and CE3.

The second auxiliary electrodes 521, 522, and 523 may include transparent conductive oxide (TCO). The transparent conductive oxide material of the second auxiliary electrodes 521, 522, and 523 may be the material exemplified for the first electrodes AE1, AE2, and AE3. In one embodiment, the second auxiliary electrodes 521, 522, and 523 may include indium zinc oxide (IZO), indium tin zinc oxide (ITZO), zinc indium tin oxide (ZITO), or/and indium gallium zinc oxide (IGZO). In one embodiment, the second auxiliary electrodes 521, 522, and 523 may include indium zinc oxide (IZO) and/or indium gallium zinc oxide (IGZO).

In one embodiment, the second auxiliary electrodes 521, 522, and 523 may include a material different from the first auxiliary electrodes 511, 512, and 513 and the first connection electrode 514. In one embodiment, a thickness t2 of the second auxiliary electrodes 521, 522, and 523 may be greater than a thickness t1 of the first auxiliary electrodes 511, 512, and 513, respectively and a thickness t3 of the first connection electrode 514. In this case, a decrease in light efficiency due to light reflection from the first electrodes AE1, AE2, and AE3 can be prevented while increasing the cathode voltage or common voltage injection. As used herein, the "thickness" of a certain electrode or layer is measured at a center of a flat bottom portion of the electrode or layer in the third direction DR3, unless mentioned otherwise.

A capping layer (not shown) may be selectively disposed on the second electrodes CE1, CE2, and CE3 or the second auxiliary electrodes 521, 522, and 523. The capping layer may include an organic or inorganic insulating material and cover the patterns disposed on the light emitting elements ED1, ED2, and ED3. The capping layer may prevent the light emitting elements ED1, ED2, and ED3 from being damaged by external air. In an embodiment, the capping layers may include an organic material such as α-NPD, NPB, TPD, m-MTDATA, Alq₃, LiF, and/or CuPc, or an inorganic material such as aluminium oxide, titanium oxide, tantalum oxide, hafnium oxide, zinc oxide, silicon oxide, silicon nitride, and/or silicon oxynitride.

The pixel defining layer PDL may be disposed on the second passivation layer PAS2, the first electrodes AE1, AE2, and AE3, and the second electrodes CE1, CE2, and CE3. The pixel defining layer PDL may be disposed on the entire second passivation layer PAS2, and may cover a portion of the first electrodes AE1, AE2, and AE3 and expose the top surfaces of the first electrodes AE1, AE2, and AE3.

The pixel defining layer PDL may include a body portion PDL_B disposed on the edges of the second passivation layer PAS2 and the first electrodes AE1, AE2, and AE3, and a protrusion portion PDL_P disposed on the second electrodes CE1, CE2, and CE3, or the second auxiliary electrodes 521, 522, and 523.

The body portion PDL_B of the pixel defining layer PDL may include a first side PDL_S1 facing the sides of the first electrodes AE1, AE2, and AE3, a second side PDL_S3 facing the side of the top surfaces of the first electrodes AE1, AE2, and AE3, and a first lower surface PDL_S2 facing a portion of the top surfaces of the first electrodes AE1, AE2, and AE3. The second side PDL_S3 of the body portion PDL_B of the pixel defining layer PDL may overlap the first electrodes AE1, AE2, and AE3 in the thickness direction DR3 of the substrate SUB, and may protrude more toward the emission areas EA1, EA2, and EA3 than the first side PDL_S1. The first lower surface PDL_S2 of the body portion PDL_B may be a surface connecting the first side PDL_S1 and the second side PDL_S3.

The protrusion portion PDL_P of the pixel defining layer PDL may protrude more than the body portion PDL_B toward a center of a corresponding second electrode CE1, CE2, and CE3 in a plan view, and define the emission areas EA1, EA2, and EA3. The protrusion portion PDL_P of the pixel defining layer PDL may include a side PDL_S5, and the side PDL_S5 of the protrusion portion PDL_P of the pixel defining layer PDL may protrude more toward the emission areas EA1, EA2, and EA3 than the first side PDL_S1 and the second side PDL_S3 of the body portion PDL_B. The protrusion portion PDL_P of the pixel defining layer PDL may have a lower surface PDL_S4. The lower surface PDL_S4 of the protrusion portion PDL_P of the pixel defining layer PDL may be a surface connecting the side PDL_S5 of the protrusion portion PDL_P and the second side PDL_S3 of the body portion PDL_B, and may be a surface facing the top surfaces of the first electrodes AE1, AE2, and AE3.

In one embodiment, a thickness t5 of the protrusion portion PDL_P of the pixel defining layer PDL may be the same as a minimum thickness t6 of the body portion PDL_B of the pixel defining layer PDL, or smaller than the minimum thickness t6 of the body portion PDL_B.

In the display device 10 according to one embodiment, as the pixel defining layer PDL includes the protrusion portion PDL_P protruding toward the emission areas EA1, EA2, and EA3, the first auxiliary electrodes 511, 512, and 513, the light emitting layers EL1, EL2, and EL3, the second electrodes CE1, CE2, and CE3, and the second auxiliary electrodes 521, 522, and 523 may be formed through deposition and etching processes instead of a mask process. Further, it is possible to individually form different layers in the different emission areas EA1, EA2, and EA3 by the deposition process. For example, even when the light emitting layers EL1, EL2, and EL3 of the light emitting elements ED1, ED2, and ED3 and the second electrodes CE1, CE2, and CE3 are formed by a deposition process using no mask, the deposited materials may be cut off with the pixel defining layer PDL interposed therebetween by the protrusion portion PDL_P of the pixel defining layer PDL without being connected between the emission areas EA1, EA2, and EA3. By a process of forming a material for forming a specific layer on the entire surface of the display device 10 and then removing the layer formed in an undesired region by etching, it is possible to individually form different layers in the different emission areas EA1, EA2, and EA3. In the display device 10, the different light emitting elements ED1, ED2, and ED3 may be formed in the different emission areas EA1, EA2, and EA3 by the deposition and etching process without using the mask process, and an unnecessary component in the display device 10 may be omitted to minimize the area of the non-display area NDA.

The protrusion portion PDL_P of the pixel defining layer PDL may be spaced apart from the top surfaces of the first electrodes AE1, AE2, and AE3, and the body portion PDL_B of the pixel defining layer PDL may have an undercut structure. Below the lower surface PDL_S4 of the protrusion portion PDL_P of the pixel defining layer PDL, that is, in a space between the protrusion portion PDL_P of the pixel defining layer PDL and the first electrodes AE1, AE2, and AE3, the first auxiliary electrodes 511, 512, and 513, the light emitting layers EL1, EL2, and EL3, the second electrodes CE1, CE2, and CE3, and the second auxiliary electrodes 521, 522, and 523 may be disposed. A portion of the first auxiliary electrodes 511, 512, and 513, the light emitting layers EL1, EL2, and EL3, the second electrodes CE1, CE2, and CE3, and the second auxiliary electrodes 521, 522, and 523 may be disposed on the second side PDL_S3 of the body portion PDL_B of the pixel defining layer PDL. The plurality of first auxiliary electrodes 511, 512, and 513 may be spaced apart from each other with the body portion PDL_B of the pixel defining layer PDL interposed therebetween. The plurality of light emitting layers EL1, EL2, and EL3 may be spaced apart from each other with the body portion PDL_B of the pixel defining layer PDL interposed therebetween. The plurality of second electrodes CE1, CE2, and CE3 may be spaced apart from each other with the body portion PDL_B of the pixel defining layer PDL interposed therebetween. The second auxiliary electrodes 521, 522, and 523 may be spaced apart from each other with the body portion PDL_B of the pixel defining layer PDL interposed therebetween. One end and the other end of the first auxiliary electrodes 511, 512, and 513, the light emitting layers EL1, EL2, and EL3, the second electrodes CE1, CE2, and CE3, and the second auxiliary electrodes 521, 522, and 523 may overlap the protrusion portion PDL_P of the pixel defining layer PDL in the thickness direction DR3 of the substrate SUB.

In an embodiment, a width d1 of the protrusion portion PDL_P of the pixel defining layer PDL may be 0.1 µm to 1.5 µm. In one embodiment, the width d1 of the protrusion portion PDL_P of the pixel defining layer PDL may be 0.3 µm to 1.0 µm. In the above range, the first auxiliary electrodes 511, 512, and 513, the light emitting layers EL1, EL2, and EL3, the second electrodes CE1, CE2, and CE3, and the second auxiliary electrodes 521, 522, and 523 in a space above the first electrodes AE1, AE2, and AE3 may be cut by the protrusion portion PDL_P of the pixel defining layer PDL, and the material thereof may also be disposed on the side of the body portion PDL_B. Here, the width d1 of the protrusion portion PDL_P of the pixel defining layer PDL may be measured as a distance of one end and the other end of the lower surface PDL_S4 of the protrusion portion PDL_P in the extending direction of a major surface of the substrate SUB in a cross-sectional view.

The pixel defining layer PDL may include an inorganic insulating material. The pixel defining layer PDL may include at least one of a silicon nitride, a silicon oxynitride, a silicon oxide, a titanium oxide, an aluminium oxide, a tantalum oxide, a hafnium oxide, a zinc oxide or an amorphous silicon, but the present disclosure is not limited thereto. In one embodiment, the pixel defining layer PDL may be at least one of a silicon nitride, a silicon oxynitride, or a silicon oxide. In one embodiment, the pixel defining layer PDL may be a single layer or a multilayer.

The first connection electrode 514 may be disposed on the pixel defining layer PDL. The first connection electrode 514 may be disposed on the top surface of the body portion PDL_B and the top surface of the protrusion portion PDL_P of the pixel defining layer PDL. The first connection electrode 514 may be disposed between the second electrodes CE1, CE2, and CE3 of the light emitting elements ED1, ED2, and ED3 to electrically connect the second electrodes CE1, CE2, and CE3 and decrease resistance. In addition, the first connection electrode 514 (etch stopper) may prevent the pixel defining layer PDL from being etched during the manufacturing process of the display device 10.

In one embodiment, the first connection electrode 514 may be formed at the same time as the first auxiliary electrodes 511, 512, and 513, and may include the same material as the first auxiliary electrodes 511, 512, and 513. The first connection electrode 514 may include transparent conductive oxide (TCO). The transparent conductive oxide material of the first connection electrode 514 may be the material exemplified for the first electrodes AE1, AE2, and AE3. In one embodiment, the first connection electrode 514 may include indium tin oxide (ITO) or/and tungsten oxide (WOₓ). In one embodiment, the thickness t1 of the first auxiliary electrodes 511, 512, and 513 and the thickness t3 of the first connection electrode 514 may be the same. In the case where the thicknesses are the same, other values within the margin of error may be included. In one embodiment, the thickness t3 of the first connection electrode 514 may be smaller than each of the thicknesses t1 of the first auxiliary electrodes 511, 512, and 513.

In one embodiment, the first connection electrode 514 may include a material different from the second auxiliary electrodes 521, 522, and 523. In one embodiment, the thickness t3 of the first connection electrode 514 may be smaller than each of the thicknesses t2 of the second auxiliary electrodes 521, 522, and 523.

The second connection electrode 530 may be disposed on the second auxiliary electrodes 521, 522, and 523, the pixel defining layer PDL, and the first connection electrode 514. The second connection electrode 530 may cover the outer surfaces of the second auxiliary electrodes 521, 522, and 523, the pixel defining layer PDL, and the first connection electrode 514. The second connection electrode 530 may be disposed on the second side PDL_S3 of the body portion PDL_B of the pixel defining layer PDL and the lower surface PDL_S4 and the side PDL_S5 of the protrusion portion PDL_P of the pixel defining layer PDL. The second connection electrode 530 may be disposed on the front surface of the substrate SUB and electrically connect the second electrodes CE1, CE2, and CE3, or the second auxiliary electrodes 521, 522, and 523.

In one embodiment, the second connection electrode 530 may include a transparent conductive oxide (TCO). The transparent conductive oxide of the second connection electrode 530 may be the material exemplified for the first electrodes AE1, AE2, and AE3. In one embodiment, the second connection electrode 530 may include indium zinc oxide (IZO), indium tin zinc oxide (ITZO), zinc indium tin oxide (ZITO), or/and indium gallium zinc oxide (IGZO). In one embodiment, the second connection electrode 530 may include indium zinc oxide (IZO) and/or indium gallium zinc oxide (IGZO).

In one embodiment, the second connection electrode 530 may include a material different from the first auxiliary electrodes 511, 512, and 513 and the first connection electrode 514. In one embodiment, the thickness t4 of the second connection electrode 530 may be greater than each of the thicknesses t1 of the first auxiliary electrodes 511, 512, and 513 and the thickness t3 of the first connection electrode 514. In one embodiment, the sum of the thicknesses t2+t4 of the second auxiliary electrodes 521, 522, and 523 and the second connection electrode 530 may be greater than each of the thicknesses t1 of the first auxiliary electrodes 511, 512, and 513.

The thin film encapsulation layer TFEL may be disposed on the light emitting elements ED1, ED2, and ED3, the pixel defining layer PDL, and the connection electrodes 514 and 530. The thin film encapsulation layer TFEL may include at least one inorganic layer to prevent oxygen or moisture from permeating into the light emitting element layer EML. The thin film encapsulation layer TFEL may include at least one organic layer to protect the light emitting element layer EML from foreign substances such as dust.

In an embodiment, the thin film encapsulation layer TFEL may include a lower inorganic encapsulation layer TFE1, an organic encapsulation layer TFE2, and an upper inorganic encapsulation layer TFE3. The lower inorganic encapsulation layer TFE1, the organic encapsulation layer TFE2, and the upper inorganic encapsulation layer TFE3 may be formed on the entire surface of the substrate SUB.

Each of the lower inorganic encapsulation layer TFE1 and the upper inorganic encapsulation layer TFE3 may include one or more inorganic insulators. The inorganic insulating material may be any one of silicon oxide, silicon nitride, and silicon oxynitride, and may include, for example, aluminium oxide, titanium oxide, tantalum oxide, hafnium oxide, zinc oxide, silicon oxide, silicon nitride, and/or silicon oxynitride.

The organic encapsulation layer TFE2 may include a polymer-based material. Examples of the polymer-based material may include acrylic resin, epoxy resin, polyimide, polyethylene and the like. For example, the organic encapsulation layer TFE2 may include an acrylic resin, for example, polymethyl methacrylate, polyacrylic acid, or the like. The organic encapsulation layer TFE2 may be formed by curing a monomer or applying a polymer.

A light blocking layer (not shown) may be selectively disposed on the thin film encapsulation layer TFEL. The light blocking layer may be positioned between the emission areas EA1, EA2, and EA3. The light blocking layer may include a light absorbing material. For example, the light blocking layer may include an inorganic black pigment or an organic black pigment. The inorganic black pigment may be carbon black, and the organic black pigment may include at least one of lactam black, perylene black, or aniline black, but they are not limited thereto. The light blocking layer may prevent visible light infiltration and color mixture between the first to third emission areas EA1, EA2, and EA3, which leads to the improvement of color reproducibility of the display device 10.

The display device 10 may include the plurality of color filters CF1, CF2, and CF3 disposed on the emission areas EA1, EA2, and EA3. Each of the plurality of color filters CF1, CF2, and CF3 may include a filtering pattern area and a light blocking area. The filtering pattern areas may be formed to overlap the emission areas EA1, EA2, and EA3, and may form a light exit area from which the light emitted from the emission areas EA1, EA2, and EA3 is emitted. The light blocking area is an area in which the plurality of color filters CF1, CF2, and CF3 are stacked so that light cannot be transmitted.

The color filters CF1, CF2, and CF3 may include a first color filter CF1, a second color filter CF2, and a third color filter CF3 disposed to correspond to the different emission areas EA1, EA2, and EA3, respectively. The color filters CF1, CF2, and CF3 may include a colorant such as a dye or a pigment that absorbs light in a wavelength band other than a specific wavelength band, and may be disposed to correspond to the color of the light emitted from the emission areas EA1, EA2, and EA3. For example, the first color filter CF1 may be a red color filter that is disposed to overlap the first emission area EA1 and transmits only the first light of the red color. The second color filter CF2 may be a green color filter that is disposed to overlap the second emission area EA2 and transmits only the second light of the green color, and the third color filter CF3 may be a blue color filter that is disposed to overlap the third emission area EA3 and transmits only the third light of the blue color.

In the display device 10, the color filters CF1, CF2, and CF3 are disposed to overlap each other, so that the intensity of the reflected light by external light may be reduced. Furthermore, the color of the reflected light by the external light may be controlled by adjusting the disposition, shape, and area of the color filters CF1, CF2, and CF3 in plan view.

An overcoat layer OC may be disposed on the color filters CF1, CF2, and CF3 to planarize the top ends of the color filters CF1, CF2, and CF3. The overcoat layer OC may be a colorless light transmissive layer that does not have a color in a visible light band. For example, the overcoat layer OC may include a colorless light transmissive organic material such as an acrylic resin.

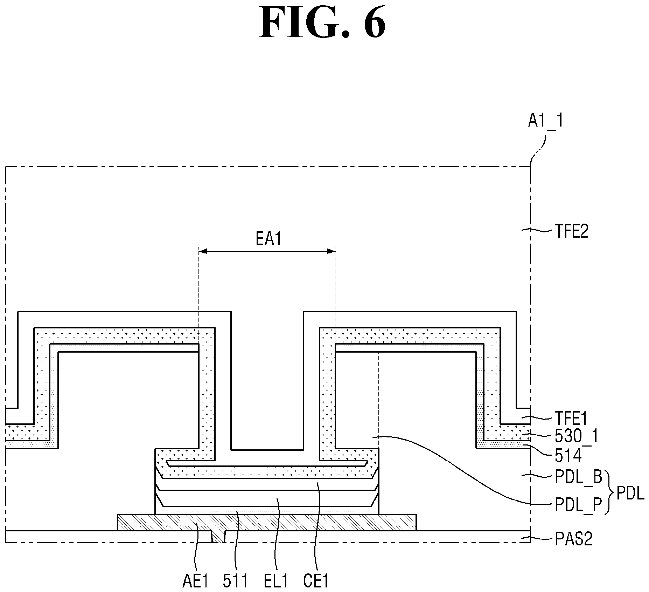

FIG. 6 is a cross-sectional view illustrating a portion (area A1_1) of a display device 10 according to one embodiment. In FIG. 6, the second auxiliary electrodes 521, 522, and 523 are omitted which is different from FIG. 5. A second connection electrode 530_1 may be disposed on the second electrodes CE1, CE2, and CE3, and the second electrodes CE1, CE2, and CE3 may be in direct contact with the second connection electrode 530_1 and electrically connected to each other. Other than the second auxiliary electrodes 521, 522, and 523 being emitted, other configurations are the same as described in FIGS. 4 and 5, and a detailed description thereof will be omitted.

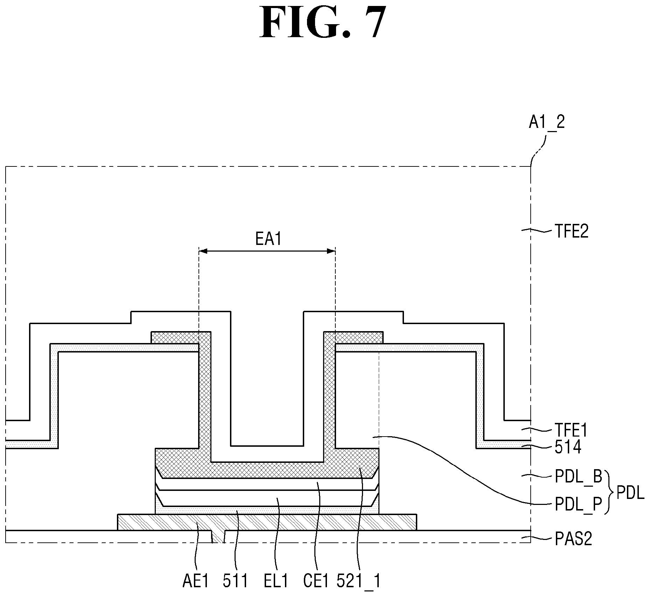

FIG. 7 is a cross-sectional view illustrating a portion (area A1_2) of a display device 10 according to one embodiment. In FIG. 7, the second common electrode 530 is omitted and a second auxiliary electrode 521_1 disposed on the lower surface PDL_S4, the side PDL_S5, and the top surface of the protrusion portion PDL_P of the pixel defining layer PDL is different from the second auxiliary electrode 521 of FIG. 5. The second auxiliary electrode 521_1 may be in contact with the first connection electrode 514 and electrically connected to the second auxiliary electrodes spaced apart from each other. The lower inorganic encapsulation layer TFE1 may be disposed on the second auxiliary electrode 521_1 and the first connection electrode 514.

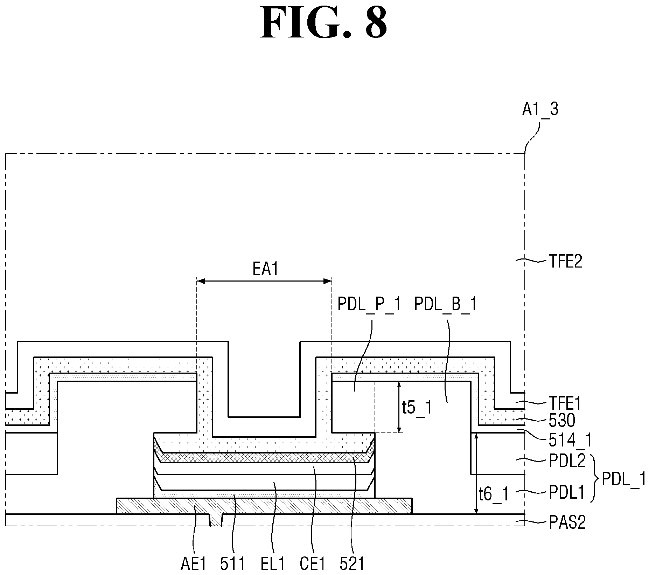

FIG. 8 is a cross-sectional view illustrating a portion (area A1_3) of a display device 10 according to one embodiment. In FIG. 8, a pixel defining layer PDL_1 being a multilayer is different from FIG. 5.

The pixel defining layer PDL_1 includes a first layer PDL1 disposed on the second passivation layer PAS2, a first electrode AE1 and a second electrode CE1, and a second layer PDL2 disposed on the first layer PDL 1. The first layer PDL1 and the second layer PDL2 may contain different materials, or include the same material but have a different film properties or physical properties from each other. A first connection electrode 514_1 may be disposed on the first layer PDL1 and the second layer PDL2 of the pixel defining layer PDL.

A body portion PDL_B_1 of the pixel defining layer PDL_1 may include the first layer PDL1 and the second layer PDL2, and a protrusion portion PDL_P_1 may include the first layer PDL1. When the first layer PDL1 and the second layer PDL2 have different etch rates, a thickness t5_1 of the protrusion portion PDL_P_1 of the pixel defining layer PDL_1 may be adjusted. In one embodiment, the thickness t5 _1 of the protrusion portion PDL_P_1 of the pixel defining layer PDL_1 may be smaller than the thickness t5 of the protrusion portion PDL_P of FIG. 5. In one embodiment, the thickness t5_1 of the protrusion portion PDL_P_1 of the pixel defining layer PDL_1 may be smaller than the minimum thickness t6_1 of the body portion PDL_B_1.

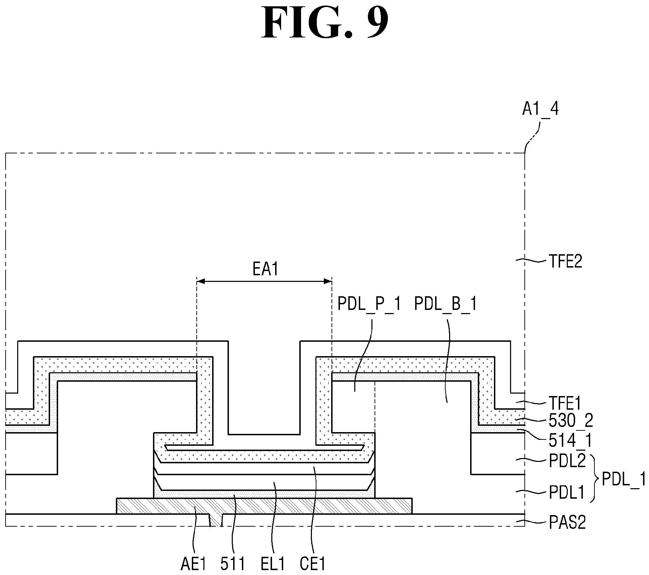

FIG. 9 is a cross-sectional view illustrating a portion (area A1_4) of a display device 10 according to one embodiment. In FIG. 9, the second auxiliary electrodes 521, 522, and 523 are omitted which is different from FIG. 8. A second connection electrode 530_2 may be disposed on the second electrodes CE1, CE2, and CE3, and the second electrodes CE1, CE2, and CE3 may be in direct contact with the second connection electrode 530_2 and electrically connected to each other.

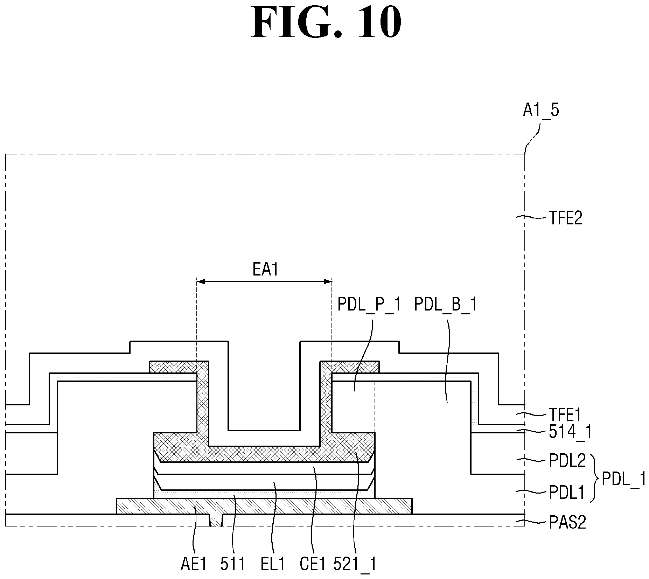

FIG. 10 is a cross-sectional view illustrating a portion (area A1_5) of a display device 10 according to one embodiment. In FIG. 10, the second connection electrode 530 is omitted, and a second auxiliary electrode 521_1 is disposed on the lower surface PDL_S4, the side PDL_S5 and the top surface of the protrusion portion PDL_P_1 of the pixel defining layer PDL_1 which is different from FIG. 8. The second auxiliary electrode 521_1 may be in contact with the first connection electrode 514_1 and electrically connected to the second auxiliary electrodes spaced apart from each other. The lower inorganic encapsulation layer TFE1 may be disposed on the second auxiliary electrode 521_1 and the first connection electrode 514_1.

Hereinafter, a fabrication process of the display device 10 according to one embodiment will be described with reference to other drawings.

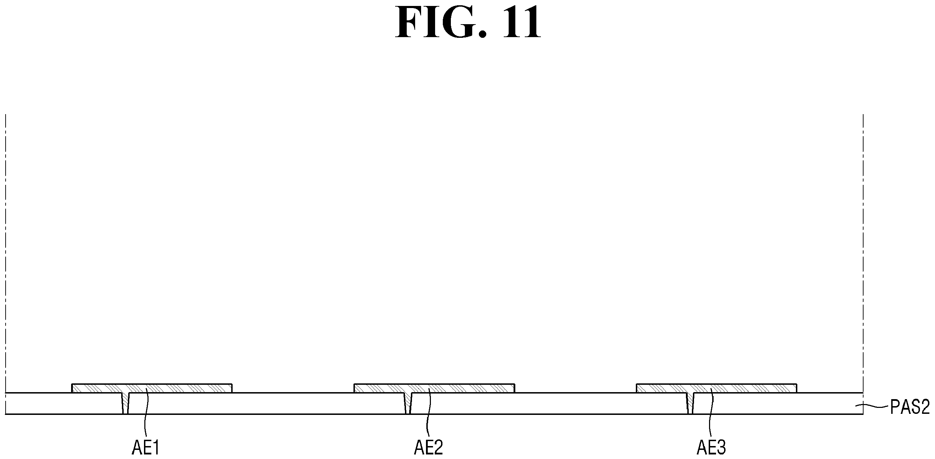

FIGS. 11 to 24 are detailed cross-sectional views sequentially illustrating a fabrication process of a display device according to one embodiment. FIGS. 11 to 24 schematically illustrate a process of forming the first electrodes AE1, AE2, and AE3, the first auxiliary electrodes 511, 512, and 513, the first connection electrode 514, the light emitting layer EL1, EL2, and EL3, the second electrodes CE1, CE2, and CE3, the second auxiliary electrodes 521, 522, and 523, the pixel defining layer PDL, and the second connection electrode 530 as the light emitting element layer EML of the display device 10. Hereinafter, a process of forming each layer with respect to a fabricating process of the display device 10 will be omitted, and a formation order of each layer will be described.

Referring to FIG. 11, the plurality of first electrodes AE1, AE2, and AE3 are formed on the second passivation layer PAS2.

Although not illustrated in the drawing, the thin film transistor layer TFTL may be disposed on the substrate SUB, and the structure of the thin film transistor layer TFTL is the same as described above with reference to FIG. 4. A detailed description thereof will be omitted.

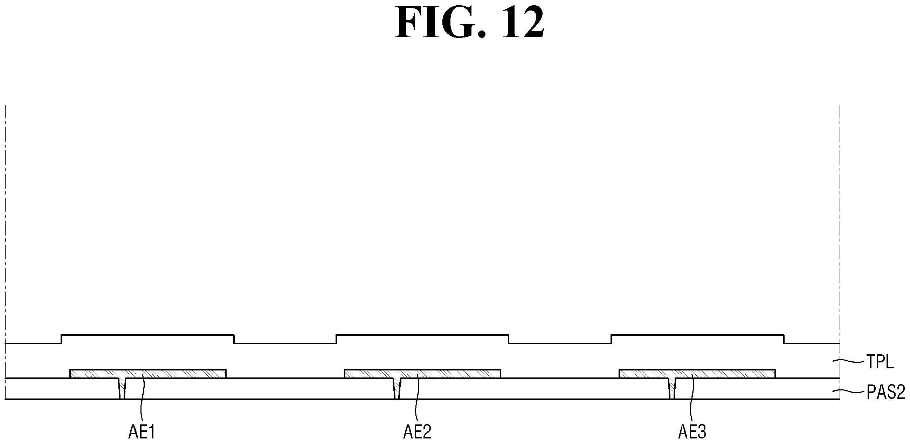

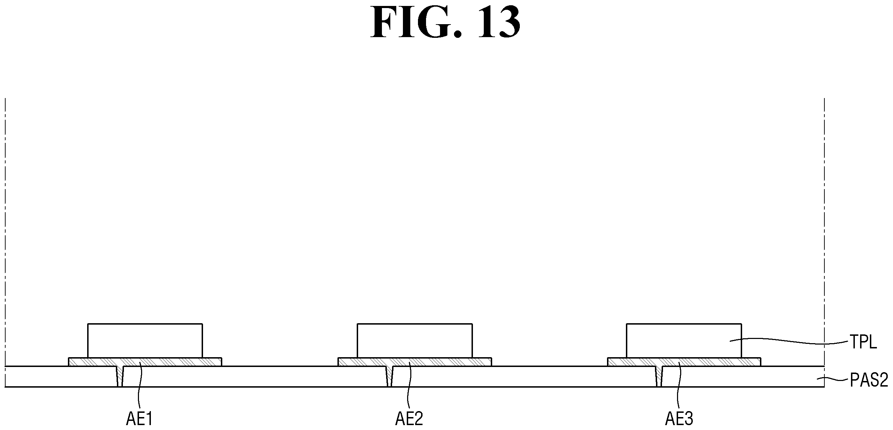

Next, referring to FIGS. 12 and 13, a temporary layer TPL is formed on the second passivation layer PAS2 and the first electrodes AE1, AE2, and AE3, and a first etching process of patterning the temporary layer TPL is performed. In one embodiment, the temporary layer TPL may include indium zinc oxide (IZO) or indium gallium zinc oxide (IGZO). There may be a plurality of patterned temporary layers TPL and the plurality of patterned temporary layers TPL may be disposed on the first electrodes AE1, AE2, and AE3. The patterned temporary layer TPL may have a narrower width than the first electrodes AE1, AE2, and AE3, and the edge of the first electrodes AE1, AE2, and AE3 may not be covered by the temporary layer TPL and be exposed.

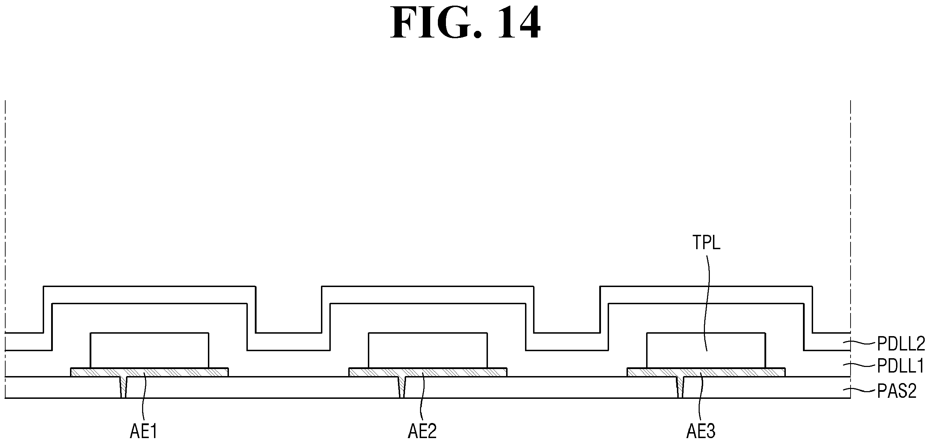

Next, referring to FIG. 14, pixel defining material layers PDLL1 and PDLL2 are formed on the second passivation layer PAS2, the first electrodes AE1, AE2, and AE3, and the temporary layers TPL. The pixel defining material layers PDLL1 and PDLL2 may include a first layer PDLL1 and a second layer PDLL2. In the case where the pixel defining material layers PDLL1 and PDLL2 are multilayers like in FIG. 14, they can be pixel defining layers PDL of a multilayer like the display devices 10 of FIGS. 8 to 10. However, the present disclosure is not limited thereto, and a pixel defining material layer of a single layer can be applied.

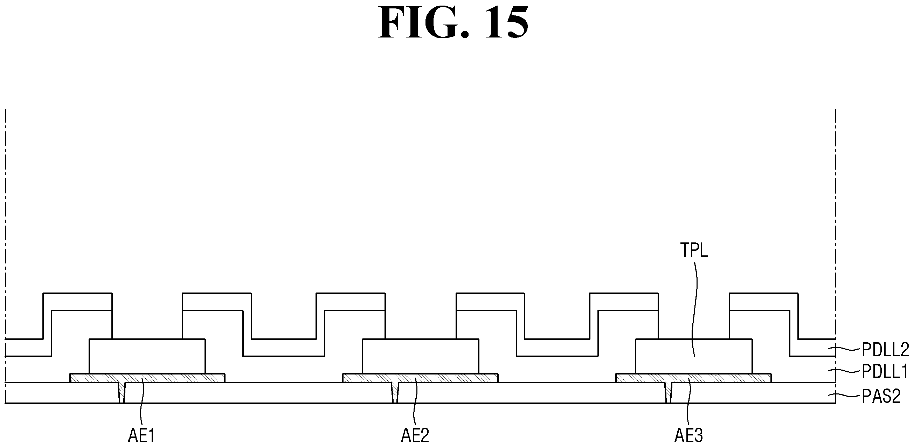

Subsequently, referring to FIG. 15, a second etching process etching a partial area of the pixel defining material layers PDLL1 and PDLL2 are performed. Through the second etching process, a portion of the temporary layer TPL may be exposed. The edge of the temporary layer TPL may be covered by the pixel defining material layers PDLL1 and PDLL2. The pixel defining material layers PDLL1 and PDLL2 on the temporary layer TPL may become the protrusion portion PDL_P of the pixel defining layer PDL thereafter, and the pixel defining material layers PDLL1 and PDLL2 on the second passivation layer PAS2 and the first electrodes AE1, AE2, and AE3 may become a body portion PDL_B of the pixel defining layer PDL thereafter.

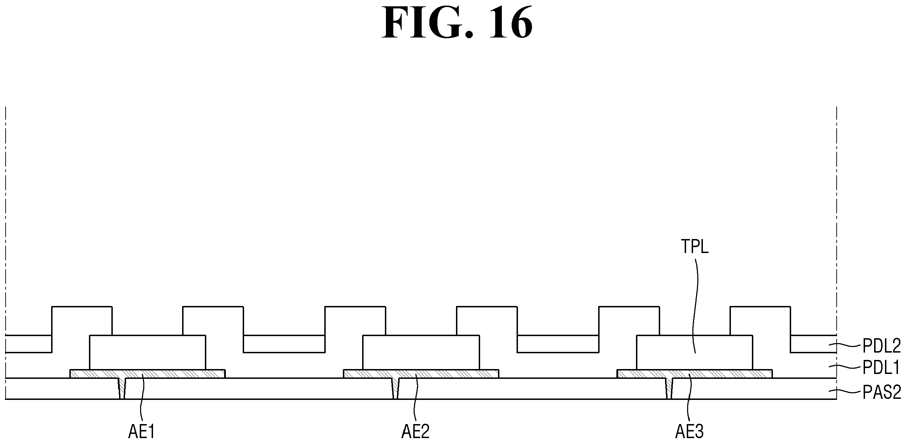

Next, referring to FIG. 16, a third etching process removing a portion of pixel defining material layers PDLL1 and PDLL2 is performed. Through the third etching process, the pixel defining layer PDL may be obtained. In the case where the first layer PDLL1 and the second layer PDLL2 of the pixel defining material layers PDLL1 and PDLL2 have different etch rates, the upper surface of the pixel defining layer PDL may have different materials or film properties for each area. In addition, the protrusion portion PDL_P of the pixel defining layer PDL may have a thickness thinner than the body portion PDL_B. In the case where the pixel defining material layer is a single layer, the third etching process of FIG. 16 may be omitted.

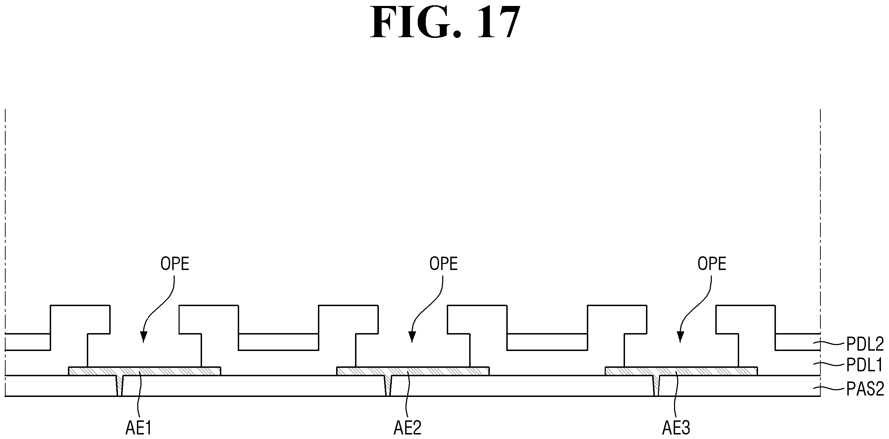

Subsequently, referring to FIG. 17, a fourth etching process removing the temporary layer TPL is performed. Through the fourth etching process, openings OPE of the pixel defining layer PDL may be formed. The openings OPE of the pixel defining layer PDL may overlap the first electrodes AE1, AE2, and AE3 in a plan view, and the pixel defining layer PDL may have an undercut structure with a protrusion portion PDL_P.

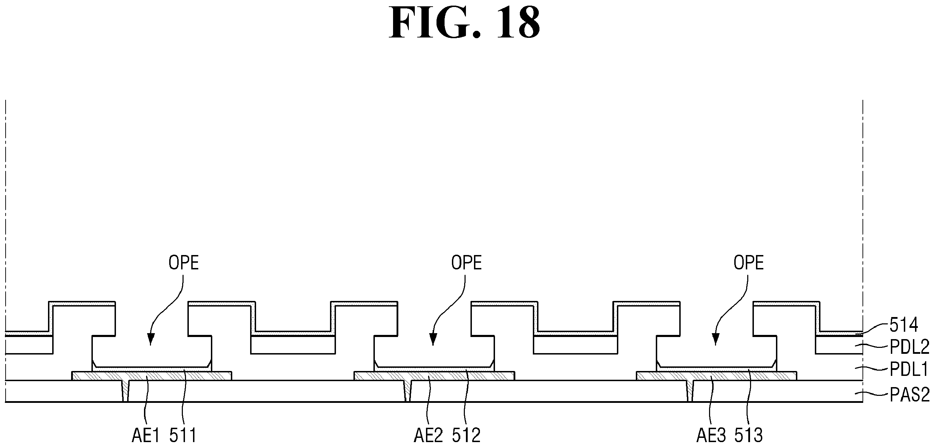

Next, referring to FIG. 18, the first auxiliary electrodes 511, 512, and 513 are formed on the first electrodes AE1, AE2, and AE3, and the first connection electrode 514 is formed on the pixel defining layer PDL. The first auxiliary electrodes 511, 512, and 513 and the first connection electrode 514 may be separated by the protrusion portion PDL_P of the pixel defining layer PDL. In the opening OPE of the pixel defining layer PDL, while forming the first auxiliary electrodes 511, 512, and 513 on the first electrodes AE1, AE2, and AE3, the first connection electrode 514 may be formed on the pixel defining layer PDL.

Meanwhile, within the undercut structure of the pixel defining layer PDL, material deposition may not be smooth due to the protrusion portion PDL_P of the pixel defining layer PDL. However, the materials of the first auxiliary electrodes 511, 512, and 513 and the first connection electrode 514 may be deposited in an inclined direction rather than the direction perpendicular to the top surface of the substrate, so that a deposition may occur even in an area covered by the protrusion portion PDL_P of the pixel defining layer PDL.

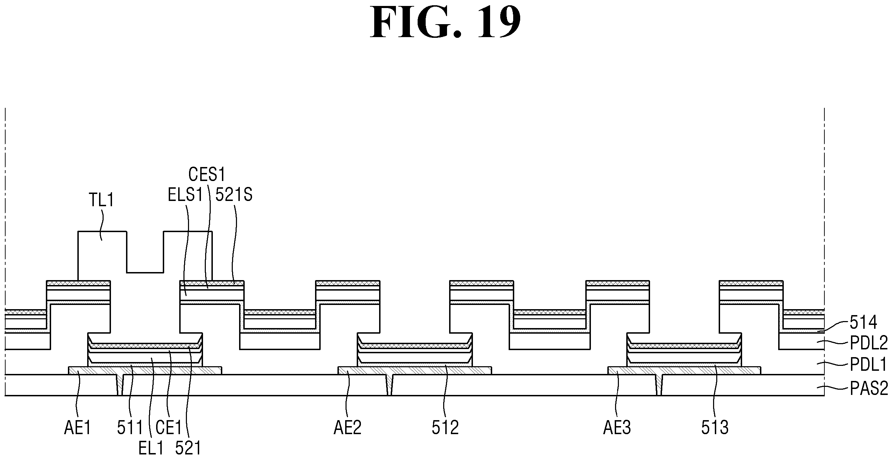

Subsequently, referring to FIG. 19, the light emitting layer EL1, the second electrode CE1, and the second auxiliary electrode 521 are formed on the first auxiliary electrode 511, and a sub-light emitting layer ELS1, a second sub-electrode CES1, and a second sub-auxiliary electrode 521S are formed on the first connection electrode 514. The light emitting layer EL1, the second electrode CE1 and the second auxiliary electrode 521 may be separated from the sub-light emitting layer ELS1, the second sub-electrode CES1, and the second sub-auxiliary electrode 521S on the first connection electrode 514, respectively, by the protrusion portion PDL_P of the pixel defining layer PDL.

A first inorganic layer TL1 may be formed on the second auxiliary electrode 521 and the second sub-auxiliary electrode 521S. In one embodiment, the first inorganic layer TL1 may be formed through chemical vapor deposition (CVD). The first inorganic layer TL1 may be formed to completely cover the outer surfaces of the first light emitting element ED1, the pixel defining layer PDL, the second auxiliary electrode 521, and the second sub-auxiliary electrode 521S without any disconnections. The first inorganic layer TL1 is formed on the top surface of the second auxiliary electrode 521, the second side PDL_S3 of the body portion PDL_B of the pixel defining layer PDL, the lower surface PDL_S4 and the side PDL_S5 of the protrusion portion PDL_P of the pixel defining layer PDL, the side of the sub-light emitting layer ELS1, the side of the second sub-electrode CES1, and the side and the top surface of the second sub-auxiliary electrode 521S.

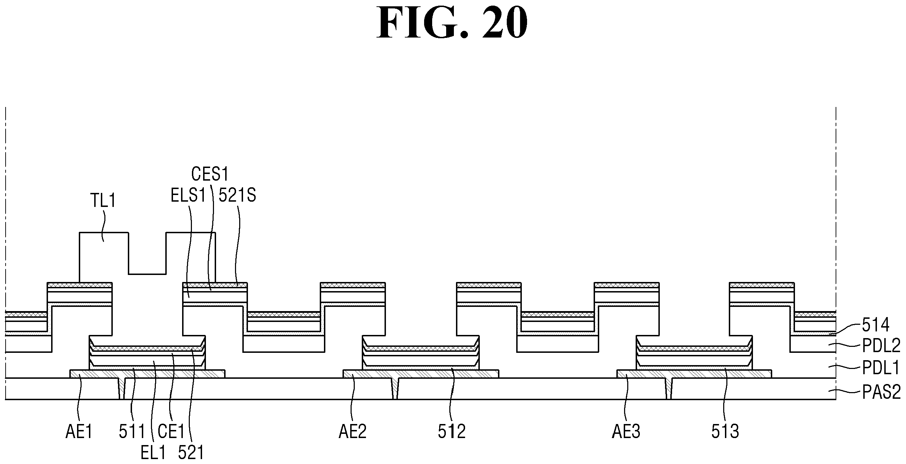

Next, referring to FIG. 20, a fifth etching process removing a portion of the first inorganic layer TL1 to expose the second sub-auxiliary electrode 521S is performed. The first inorganic layer TL1 in other areas may be removed, leaving only the first inorganic layer TL1 in the first emission area EA1 and the peripheral area. The first inorganic layer TL1 does not overlap the second emission area EA2 and the third emission area EA3 in a plan view.

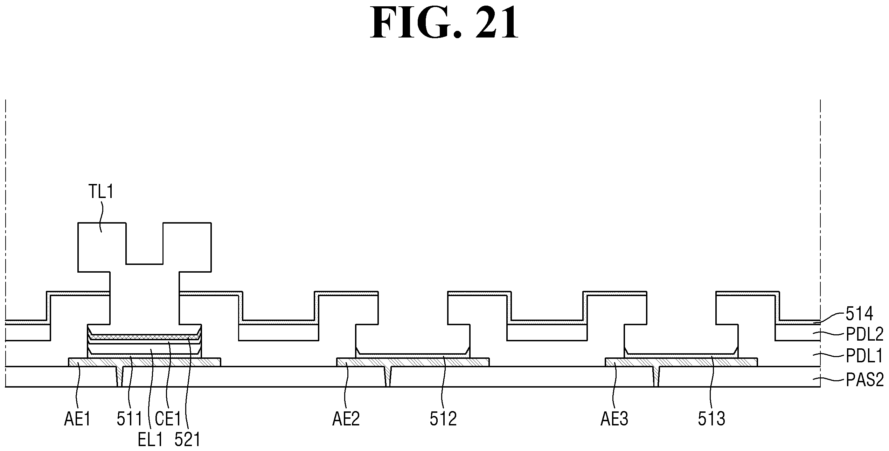

Subsequently, referring to FIG. 21, a sixth etching process removing the sub-light emitting layer ELS1, the second sub-electrode CES1, and the second sub-auxiliary electrode 521S is performed. The light emitting layer EL1, the second electrode CE1, and the second auxiliary electrode 521 overlapping the second emission area EA2 and the third emission area EA3 may also be removed. At this time, the first connection electrode 514 may not be removed and prevent the pixel defining layer PDL from being etched.

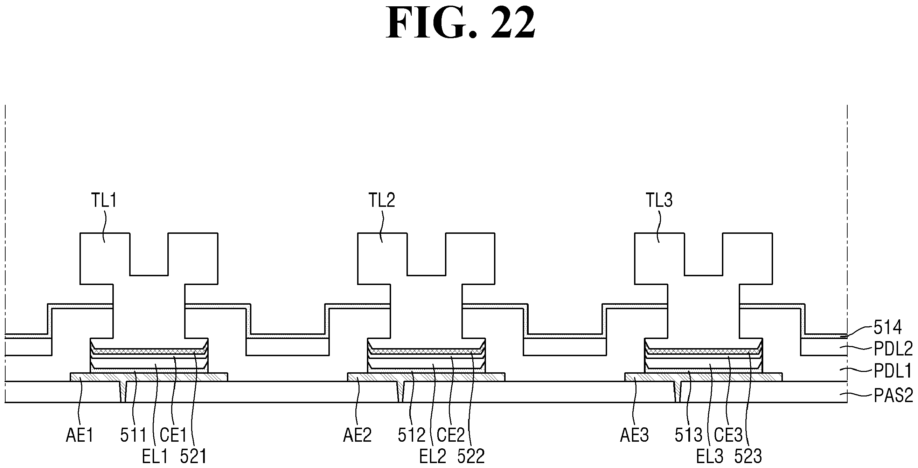

Next, referring to FIG. 22, by repeating the process of FIGS. 19 through 21, the light emitting layer EL2, the second electrode CE2, the second auxiliary electrode 522, and a second inorganic layer TL2 may be formed on the second emission area EA2, and the light emitting layer EL3, the second electrode CE3, the second auxiliary electrode 523, and a third inorganic layer TL3 may be formed on the third emission area EA3. The light emitting layer EL2, the second electrode CE2, the second auxiliary electrode 522, and the second inorganic layer TL2 of the second emission area EA2 may not overlap the first emission area EA1 and the third emission area EA3. The light emitting layer EL3, the second electrode CE3, the second auxiliary electrode 523, and the third inorganic layer TL3 of the third emission area EA3 may not overlap the first emission area EA1 and the second emission area EA2.

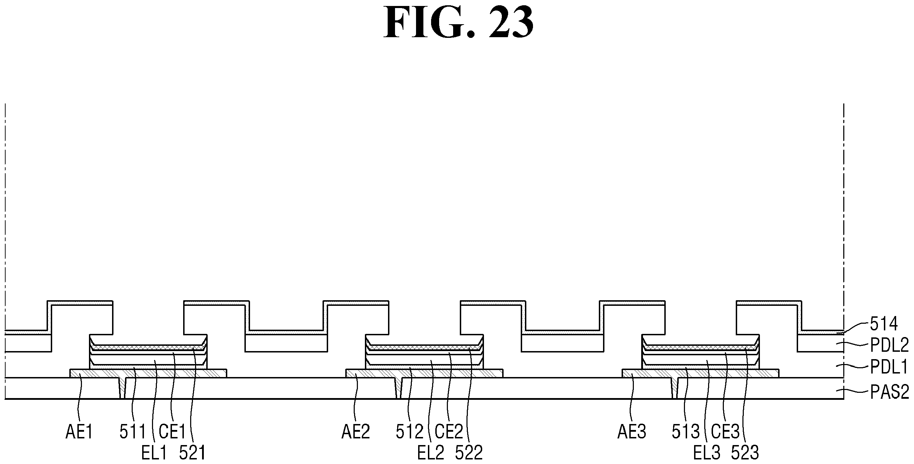

Subsequently, referring to FIG. 23, a seventh etching process of removing the first to third inorganic layers TL1, TL2, and TL3 is performed. The first to third inorganic layers TL1, TL2, and TL3 may be removed in the openings OPE of the pixel defining layer PDL, and the second auxiliary electrodes 521, 522, and 523 may be exposed.

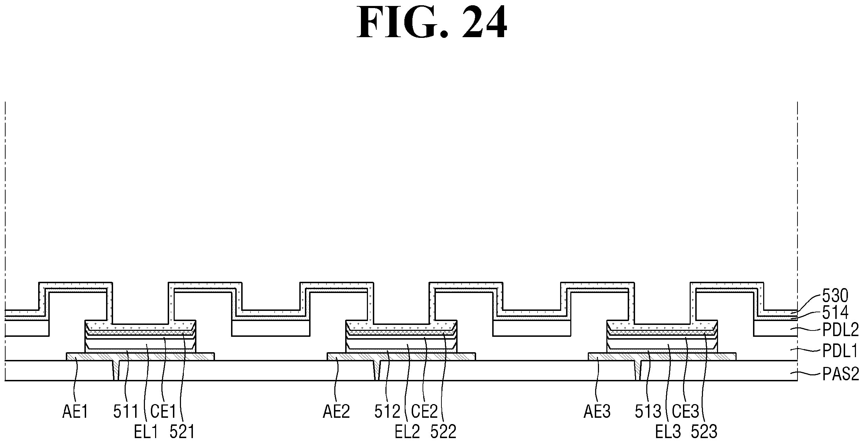

Next, referring to FIG. 24, the second connection electrode 530 is formed on the second auxiliary electrodes 521, 522, and 523 and the first connection electrode 514. The second connection electrode 530 may cover the entire surface of the substrate SUB.

Subsequently, although not shown in the drawings, by forming the lower inorganic encapsulation layer TFE1, the organic encapsulation layer TFE2, and the upper inorganic encapsulation layer TFE3 of the thin film encapsulation layer TFEL and the color filter layer CFL, and the overcoat layer OC on the light emitting elements ED1, ED2, and ED3, the pixel defining layer PDL, and the connection electrodes 514 and 530, the display device 10 is fabricated. The structure of the thin film encapsulation layer TFEL, the color filter layer CFL, and the overcoat layer OC is the same as described above, so a detailed description thereof will be omitted.

In concluding the detailed description, those skilled in the art will appreciate that many variations and modifications can be made to the preferred embodiments without substantially departing from the principles of the present disclosure. Therefore, the disclosed preferred embodiments of the invention are used in a generic and descriptive sense only and not for purposes of limitation.

## Claims

1. A display device comprising:
a first electrode disposed on a substrate;
a first auxiliary electrode disposed on the first electrode, and having a width narrower than the first electrode;
a light emitting layer disposed on the first auxiliary electrode;
a second electrode disposed on the light emitting layer; and
a pixel defining layer comprising a body portion disposed on a portion of the first electrode and the substrate, not on the second electrode, and a protrusion portion disposed on the second electrode.

2. The display device of claim 1,
wherein a side of the protrusion portion of the pixel defining layer protrudes more than a side of the body portion toward a center of the second electrode in a plan view.

3. The display device of claim 1 or claim 2,
wherein the first auxiliary electrode is disposed on a side of the body portion of the pixel defining layer.

4. The display device of any one of claims 1 to 3,
wherein a width of the protrusion portion of the pixel defining layer is 0.1 µm to 1.5 µm.

5. The display device of any one of claims 1 to 4, further comprising:
a first connection electrode disposed on the body portion and the protrusion portion of the pixel defining layer, and comprising a same material as the first auxiliary electrode, optionally wherein a thickness of the first auxiliary electrode and a thickness of the first connection electrode are the same.

6. The display device of claim 5, further comprising:
a second auxiliary electrode disposed on the second electrode.

7. The display device of claim 6,
wherein:
(i) a thickness of the second auxiliary electrode is greater than a thickness of the first auxiliary electrode; and/or
(ii) the first auxiliary electrode, the first connection electrode, and the second auxiliary electrode comprise transparent conductive oxide (TCO).

8. The display device of claim 6 or claim 7, wherein:
(i) the display device further comprises:
a second connection electrode disposed on the second auxiliary electrode and the first connection electrode, optionally
wherein the first auxiliary electrode and the first connection electrode comprises Indium Tin Oxide (ITO) or Tungsten Oxide (WOₓ), and
the second auxiliary electrode and the second connection electrode comprises Indium Zinc Oxide (IZO), Indium Tin Zinc Oxide (ITZO), Zinc Indium Tin Oxide (ZITO), or Indium Gallium Zinc Oxide (IGZO); or
(ii) the second auxiliary electrode is disposed on a side and an upper surface of the protrusion portion of the pixel defining layer.

9. The display device of claim 5, further comprising:
a second connection electrode directly disposed on the second electrode and the first connection electrode.

10. The display device of any one of claims 1 to 9,
wherein the pixel defining layer comprises at least one of silicon nitride, silicon oxynitride, or silicon oxide.

11. The display device of any one of claims 1 to 10,
wherein:
(i) the pixel defining layer is a single layer or a multilayer; or
(ii) the body portion of the pixel defining layer comprises a first layer and a second layer, and
the protrusion portion of the pixel defining layer comprises the first layer, optionally
wherein a thickness of the protrusion portion of the pixel defining layer is smaller than a minimum thickness of the body portion of the pixel defining layer.

12. A display device comprising:
a substrate comprising a first emission area and a second emission area;
a pixel defining layer comprising a body portion disposed on the substrate and a protrusion portion defining the first emission area and the second emission area but spaced apart from the upper surface of the substrate;
a first electrode, a first auxiliary electrode, a light emitting layer, and a second electrode sequentially disposed on the substrate in the first emission area;
a first electrode, a first auxiliary electrode, a light emitting layer, and a second electrode sequentially disposed on the substrate in the second emission area; and
a connection electrode disposed on the second electrodes and the pixel defining layer,
wherein the second electrode of the first emission area and the second electrode of the second emission area are spaced apart from each other and electrically connected through the connection electrode,
and at least a portion of the second electrode of the first emission area and at least a portion of the second electrode of the second emission area are disposed between the substrate and the protrusion portion of the pixel defining layer in a thickness direction of the substrate.

13. The display device of claim 12, wherein:
(i) the connection electrode comprises:
a first connection electrode disposed on the pixel defining layer; and
a second connection electrode disposed on the second electrode and the first connection electrode,
wherein the first connection electrode and the second connection electrode comprise different materials from each other; or
(ii) the display device further comprises:
a second auxiliary electrode disposed on the second electrode and the connection electrode of the first emission area; and
a second auxiliary electrode disposed on the second electrode and the connection electrode of the second emission area,
wherein the second auxiliary electrodes are spaced apart from each other.

14. A method for fabrication of a display device, comprising:
forming a plurality of first electrodes spaced apart from each other on a substrate;
forming a temporary layer on the substrate and the first electrodes;
patterning the temporary layer to expose edges of the first electrodes and a portion of the substrate;
forming a pixel defining material layer on the substrate, the first electrodes, and the patterned temporary layer;
removing a portion of the pixel defining material layer to expose a portion of the patterned temporary layer; and
removing the patterned temporary layer to form an opening of the pixel defining material layer.

15. The method of claim 14, further comprising:
forming a first auxiliary electrode on the first electrodes, and the first connection electrode on the pixel defining material layer;
forming a light emitting layer on the first auxiliary electrode and a sub-light emitting layer on the first connection electrode;
forming a second electrode on the light emitting layer and a second sub-electrode on the sub-light emitting layer;
forming an inorganic layer on the second electrode and the second sub-electrode;
removing a portion of the inorganic layer; and
removing the second sub-electrode and the sub-light emitting layer to expose the first connection electrode.
